# EUROPÄISCHE PATENTSCHRIFT

(11) **EP 2 628 190 B1**
(45) Veröffentlichungstag und Bekanntmachung des Hinweises auf die Patenterteilung: **26.08.2020**
(21) Anmeldenummer: 11811521.1
(22) Anmeldetag: 14.10.2011
(51) Int. Cl.: H01L 31/18, H01L 31/0224

(54) **SOLARZELLE MIT DIELEKTRISCHER RÜCKSEITENBESCHICHTUNG UND VERFAHREN ZU DEREN HERSTELLUNG**
SOLAR CELL HAVING A DIELECTRIC REAR FACE COATING AND METHOD FOR PRODUCING SAME
CELLULE SOLAIRE À REVÊTEMENT ARRIÈRE DIÉLECTRIQUE ET SON PROCÉDÉ DE FABRICATION

(30) Priorität: 15.10.2010 DE 102010048437
(43) Veröffentlichungstag der Anmeldung: 21.08.2013
(73) Patentinhaber: RCT Solutions GmbH, 78467 Konstanz (DE)
(72) Erfinder: TEPPE, Andreas, 78467 Konstanz (DE); MÜNZER, Adolf, 85716 Unterschleißheim (DE); SCHÖNE, Jan, 78479 Reichenau (DE); HEIN, Mathias, 20149 Hamburg (DE); WINTER, Peter, 78476 Allensbach (DE)
(74) Vertreter: Heyerhoff Geiger & Partner Patentanwälte PartGmbB
(86) Internationale Anmeldenummer: PCT/DE2011/075252
(87) Internationale Veröffentlichungsnummer: WO 2012/083938

(56) Entgegenhaltungen:
- EP-A1- 1 763 086
- US-A- 4 158 591
- US-A- 6 117 266
- US-A1- 2009 211 628

## Beschreibung

Die Erfindung betrifft eine Solarzelle sowie ein Verfahren zur Herstellung einer Solarzelle.

Bei nach dem aktuellen Entwicklungsstand gefertigten Solarzellen werden häufig dielektrische Beschichtungen auf der Rückseite, d.h. der im Betriebszustand dem einfallenden Licht abgewandten Seite, der Solarzelle als optische Spiegel für langwellige Lichtanteile vorgesehen. Die fortschrittlichsten Fertigungsverfahren sehen vor, dass die dielektrische Beschichtung noch vor einer Emitterdiffusion auf ein für die Solarzellenfertigung verwendetes Solarzellensubstrat aufgebracht und im Weiteren als Diffusionsbarriere gegen eine Eindiffusion von Emitterdotierstoff in die Rückseite des Solarzellensubstrats verwendet wird. Zudem kann die dielektrische Beschichtung vor einem Texturätzen einer Vorderseite, d.h. einer im Betriebszustand dem einfallenden Licht zugewandten Seite, des Solarzellensubstrats aufgebracht und als Ätzbarriere gegenüber einem Ätzen der Rückseite des Solarzellensubstrats verwendet werden. Solche vorteilhaften Herstellungsverfahren sind in der deutschen Patentanmeldung mit Nummer 10 2010 025 983.7 beschrieben. Eine Rückkontaktsolarzelle und ein Verfahren zu deren Herstellung sind aus dem Dokument US 2009/0211628 A1 bekannt.

Dielektrische Beschichtungen erfolgen meist mittels Verfahren der chemischen Abscheidung aus der Dampfphase (CVD), insbesondere mittels Verfahren der plasmagetriebenen Abscheidung aus der Dampfphase (PECVD). Hierbei werden die Solarzellensubstrate in Haltevorrichtungen, sogenannten Booten, angeordnet, welche zum Zwecke der Beschichtung der Solarzellensubstrate in eine Beschichtungsvorrichtung eingebracht werden. Die Solarzellensubstrate sind dabei häufig im Wesentlichen vertikal in den Booten angeordnet, d.h. deren Rückseitenebenen erstrecken sich im Wesentlichen in vertikaler Richtung. Derartige Boote werden daher als Vertikalboote bezeichnet. Um die dielektrische Beschichtung möglichst auf der gesamten Rückseite des Solarzellensubstrats abscheiden zu können, sind die Vertikalboote mit Haltenasen, sogenannten Haltepins, versehen, an welchen die Solarzellensubstrate mit ihrer Vorderseite gegen eine sich im Wesentlichen vertikal erstreckende Platte gerichtet zur Anlage gebracht werden. Diese Haltenasen sind üblicherweise durch Keramik- oder Graphitstifte gebildet.

Es hat sich nun gezeigt, dass es in Umgebungen der Haltenasen zu lokalen Kurzschlüssen in der fertigen Solarzelle kommen kann, die deren Wirkungsgrad beeinträchtigen. Wie sich herausstellte, ist dies auf Abschattungseffekte der Haltenasen zurückzuführen, welche zur Folge haben können, dass die dielektrische Beschichtung in Umgebungen der Haltenasen dünner ausfällt als in übrigen Teilen der dielektrischen Beschichtung. Bei einer nachfolgenden Emitterdiffusion kann dies dazu führen, dass Dotierstoff in Umgebungen der Haltenasen lokal durch die dünne dielektrische Beschichtung hindurch in die Rückseite des Solarzellensubstrats gelangt. In Verbindung mit einem auf die Rückseite des Solarzellensubstrats aufgebrachten Kontakt kann dies zu den erwähnten lokalen Kurzschlüssen führen. Diese Gefahr vergrößert sich, wenn vor der Emitterdiffusion die dielektrische Beschichtung als Ätzbarriere verwendet wird, beispielsweise bei dem oben erwähnten Texturätzen. Dies beruht darauf, dass bei derartigen Ätzschritten die dielektrische Beschichtung durch das eingesetzte Ätzmedium angegriffen und zusätzlich ausgedünnt werden kann.

Das beschriebene Problem lässt sich umgehen, indem die Solarzellensubstrate in Horizontal- anstatt Vertikalbooten angeordnet werden, da in diesen die Solarzellensubstrate auf Platten aufgelegt werden und auf diese Weise auf Haltenasen verzichtet werden kann. Wie sich herausstellte, können jedoch in einem Horizontalboot nur etwa halb so viele Solarzellensubstrate beschichtet werden wie in einem vergleichbaren Vertikalboot. Die Verwendung von Horizontalbooten ist demzufolge mit einem erheblichen Fertigungsmehraufwand verbunden.

Eine weitere Möglichkeit zur Umgehung des beschriebenen Problems besteht darin, die Solarzellensubstrate in Beschichtungsvorrichtungen mit einem indirekten Plasma einzubringen. Es hat sich jedoch herausgestellt, dass die in derartigen Beschichtungsvorrichtungen aufgebrachten dielektrischen Beschichtungen weniger dicht sind als in Beschichtungsvorrichtungen mit einem direkten Plasma erzeugte Beschichtungen. Aufgrund ihrer geringeren Dichte eignen sich die mittels des indirekten Plasmas erzeugten dielektrischen Schichten schlechter als Diffusions- oder Ätzbarrieren. Dies beeinträchtigt ihre Verwendbarkeit in den oben beschriebenen modernen Solarzellenherstellungsverfahren.

Weiterhin kann das beschriebene Problem dadurch umgangen werden, dass auf die Rückseite des Solarzellensubstrats ein Kontakt mit verringerter Breite und verringerter Höhe aufgebracht wird. Wie sich herausgestellt hat, müssen Breite und Höhe des Kontakts jedoch vergleichsweise stark verringert werden, um eine Kontaktierung abgeschatteter Bereiche zuverlässig zu verhindern. Die damit verbundene signifikante Verringerung der Kontaktfläche führt jedoch ebenfalls zu Wirkungsgradeinbußen auf Grund von erhöhten Widerstandsverlusten.

Vor diesem Hintergrund liegt der vorliegenden Erfindung die Aufgabe zu Grunde, eine Solarzelle mit dielektrischer Beschichtung auf ihrer Rückseite und verbessertem Wirkungsgrad zur Verfügung zu stellen, die zudem aufwandsgünstig herstellbar ist.

Diese Aufgabe wird gelöst durch eine Solarzelle mit den Merkmalen des Anspruchs 8 sowie durch eine Solarzelle mit den Merkmalen des Anspruchs 9.

Vorteilhafte Weiterbildungen sind jeweils Gegenstand abhängiger Unteransprüche.

Weiterhin liegt der Erfindung die Aufgabe zu Grunde, ein Verfahren zur Verfügung zu stellen, mittels welchem Solarzellen mit dielektrischer Beschichtung auf ihrer Rückseite und verbessertem Wirkungsgrad aufwandsgünstig herstellbar sind.

Diese Aufgabe wird gelöst durch ein Verfahren mit den Merkmalen des Anspruchs 1.

Vorteilhafte Weiterbildungen sind wiederum Gegenstand abhängiger Unteransprüche.

Die erfindungsgemäße Solarzelle weist eine auf einer Rückseite der Solarzelle angeordnete dielektrische Beschichtung auf. Hierbei kann es sich beispielsweise um eine Oxid-Nitrid-Beschichtung handeln. Die dielektrische Beschichtung ist zumindest teilweise von wenigstens einem flächigen Kontakt bedeckt. Eine Berandungslinie des wenigstens einen flächigen Kontakts weist mindestens einen Rücksprung auf.

Auf diese Weise können in den durch den mindestens einen Rücksprung von dem wenigstens einen flächigen Kontakt frei gehaltenen Bereichen diejenigen Bereiche des Solarzellensubstrats angeordnet werden, welche während des Abscheidens der dielektrischen Beschichtung durch Haltenasen abgeschattet waren. Lokale Kurzschlüsse in diesen Bereichen können so vermieden werden. Zudem wird eine Gesamtfläche des flächigen Kontakts durch den mindestens einen Rücksprung nur geringfügig verringert, sodass eine Verbesserung der Solarzellenwirkungsgrade möglich ist.

Unter der Rückseite einer Solarzelle ist vorliegend eine im Betriebszustand der Solarzelle dem einfallenden Licht abgewandte, großflächige Seite der Solarzelle zu verstehen. Großflächige Seiten sind die Rück- sowie eine Vorderseite der Solarzelle, welche von kleinflächigen Kanten der Solarzelle unterschieden werden. Ein Kontakt bezeichnet vorliegend eine metallhaltige Beschichtung mittels welcher die Solarzelle elektrisch kontaktiert werden kann.

Die dielektrische Beschichtung weist in einem durch den mindestens einen Rücksprung von dem flächigen Kontakt frei gehaltenen Bereich der Rückseite der Solarzelle zumindest abschnittsweise eine Dicke von weniger als 50%, vorzugsweise von weniger als 30% und besonders bevorzugt von weniger als 10%, ihrer maximalen Dicke auf. Dies ermöglicht eine effiziente Wirkungsgradverbesserung bei wirksamer Vermeidung lokaler Kurzschlüsse.

In einer anderen Ausführungsvariante ist ein durch den mindestens einen Rücksprung von dem flächigen Kontakt frei gehaltener Bereich der Rückseite der Solarzelle zumindest abschnittsweise frei von der dielektrischen Beschichtung. Die dielektrische Beschichtung fehlt also in dem durch den mindestens einen Rücksprung von dem flächigen Kontakt frei gehaltenen Bereich der Rückseite zumindest abschnittsweise vollständig. Diese Variante hat sich insbesondere in Verbindung mit der Verwendung der dielektrischen Beschichtung als Ätzbarriere während eines Texturätzens der Vorderseite der Solarzelle bewährt.

Da in Vertikalbooten in der Regel zwei bis drei Haltenasen vorgesehen sind, weist die Berandungslinie vorzugsweise zwei, besonders bevorzugt drei, Rücksprünge auf. Diese sind so angeordnet, dass sie die durch die Haltenasen während der Abscheidung der dielektrischen Beschichtung abgeschatteten Bereiche von dem flächigen Kontakt frei halten. Eine größere Anzahl von Rücksprüngen kann bei Bedarf vorgesehen werden.

Vorteilhafterweise weist die Berandungslinie mehrere Rücksprünge auf und die Rücksprünge sind dabei spiegelsymmetrisch zu einer in einer Ebene des flächigen Kontakts verlaufenden Geraden angeordnet. In Vertikalbooten kann es vorteilhaft sein, die Haltenasen teilweise spiegelverkehrt anzuordnen. Beispielsweise wenn die Haltenasen eine im Wesentlichen vertikal verlaufende Platte des Vertikalboots durchsetzen und auf beiden Seiten der Platte als Haltenasen verwendet werden. Durch die beschriebene spiegelsymmetrische Anordnung der Rücksprünge können die während des Abscheidens der dielektrischen Beschichtung durch die Haltenasen abgeschatteten Bereiche sowohl einer auf der einen Seite der Platte des Vertikalboots wie auch einer auf der anderen Seite der Platte angeordneten Solarzelle in Rücksprüngen angeordnet werden. Dementsprechend sind insgesamt vorzugsweise vier, besonders bevorzugt sechs, Rücksprünge vorgesehen.

In der Praxis hat sich ein mittels an sich bekannter Druckverfahren aufgebrachter flächiger Kontakt bewährt, insbesondere ein mittels Siebdruck aufgebrachter Kontakt. Beispielsweise kann der flächige Kontakt durch siebgedruckte aluminiumhaltige Pasten gebildet sein.

Vorzugsweise wird die Solarzelle als Siliziumsolarzelle ausgeführt. Dabei kann es sich sowohl um eine mono- wie auch eine multikristalline Siliziumsolarzelle handeln.

Das erfindungsgemäße Verfahren sieht vor, dass ein Solarzellensubstrat in einer Haltevorrichtung angeordnet wird, indem das Solarzellensubstrat an Haltenasen zur Anlage gebracht wird. Im Weiteren wird die Haltevorrichtung in eine Beschichtungsvorrichtung eingebracht und eine dielektrische Beschichtung, beispielsweise eine Oxid-Nitrid-Beschichtung, auf der Rückseite des Solarzellensubstrats abgeschieden. Nachfolgend wird zumindest auf Teile der dielektrischen Beschichtung ein flächiger Kontakt aufgebracht. Bei diesem Aufbringen des flächigen Kontakts auf zumindest Teile der dielektrischen Beschichtung werden diejenigen Bereiche ausgespart, welche während des Abscheidens der dielektrischen Beschichtung von den Haltenasen abgeschattet gewesen sind. Auf die während des Abscheidens der dielektrischen Beschichtung abgeschattet gewesenen Bereiche wird also kein flächiger Kontakt aufgebracht.

Unter abgeschatteten, beziehungsweise abgeschattet gewesenen Bereichen, sind vorliegend Bereiche zu verstehen, in welchen eine Abscheidung der dielektrischen Beschichtung durch Haltenasen oder andere abschattende Objekte derart behindert wird, dass die Dicke der abgeschiedenen dielektrischen Beschichtung verringert ist oder überhaupt keine dielektrische Beschichtung vorliegt.

Mittels des erfindungsgemäßen Verfahrens kann die Bildung lokaler Kurzschlüsse in abgeschatteten Bereichen aufwandsgünstig verhindert und der Wirkungsgrad gefertigter Solarzellen hierdurch verbessert werden. Die erfindungsgemäße Solarzelle kann mittels des erfindungsgemäßen Verfahrens hergestellt werden.

Vorteilhafterweise wird als Haltevorrichtung ein Vertikalboot verwendet. Unter einem Vertikalboot ist dabei eine Haltevorrichtung zu verstehen, in welchem die Solarzellensubstrate im Wesentlichen vertikal angeordnet werden. D.h. die Rückseiten der Solarzellensubstrate, genauer die durch die Rückseiten festgelegten Ebenen, erstrecken sich im Wesentlichen in vertikaler Richtung. Oder in anderen Worten ausgedrückt: Die Normalenvektoren von durch Rückseitenoberflächen der Solarzellensubstrate gebildeten Ebenen erstrecken sich im Wesentlichen in horizontaler Richtung, wobei der Ausdruck "im Wesentlichen" eine Winkelabweichung von der horizontalen Richtung von bis zu 10° einschließen soll. In Vertikalbooten können mehr Solarzellensubstrate angeordnet werden als in anderen Haltevorrichtungen, was sich vorteilhaft auf den für die Solarzellenfertigung erforderlichen Aufwand auswirkt.

Bevorzugt wird ein flächiger Kontakt aufgebracht, dessen Berandungslinie wenigstens einen Rücksprung aufweist. Ferner wird der flächige Kontakt derart ausgestaltet und angeordnet, dass der wenigstens eine Rücksprung zumindest einen Teil derjenigen Bereiche von einer Bedeckung mit dem flächigen Kontakt ausspart, welche während des Abscheidens der dielektrischen Beschichtung von den Haltenasen abgeschattet gewesen sind. Dies ermöglicht eine Vermeidung lokaler Kurzschlüsse bei geringer Verringerung der Kontaktfläche, was sich positiv auf den Wirkungsgrad der Solarzelle auswirkt. Vorzugweise werden diese Bereiche vollständig von der Bedeckung mit dem flächigen Kontakt ausgespart.

Grundsätzlich können nebeneinander mehrere flächige Kontakte dieser Art aufgebracht werden, welche zusammen zweckmäßigerweise alle Bereiche von einer Bedeckung mit flächigen Kontakten aussparen, welche während des Abscheidens der dielektrischen Beschichtung von den Haltenasen abgeschattet gewesen sind.

Besonders bevorzugt wird jedoch ein flächiger Kontakt aufgebracht, dessen Berandungslinie für jeden während des Abscheidens der dielektrischen Beschichtung von Haltenasen abgeschatteten Bereich ein Rücksprung aufweist. Jeder dieser Rücksprünge wird dabei derart ausgestaltet und angeordnet, dass er denjenigen Bereich zumindest teilweise von einer Bedeckung mit dem flächigen Kontakt ausspart, welcher während des Abscheidens der dielektrischen Beschichtung von der zugehörigen Haltenase abgeschattet gewesen ist. Vorteilhafterweise werden dabei diese Bereiche vollständig von der Bedeckung mit dem flächigen Kontakt ausgespart.

Es hat sich bewährt, den flächigen Kontakt mittels an sich bekannter Druckverfahren auf die dielektrische Beschichtung, oder Teile derselben, aufzudrucken. Insbesondere können hierbei Siebdruckverfahren Verwendung finden, welche einfach und aufwandsgünstig an verschiedene Kontaktgeometrien und Formen der Berandungslinie des flächigen Kontakts angepasst werden können.

Vorzugsweise wird die dielektrische Beschichtung mittels einer plasmagetriebenen Abscheidung aus der Dampfphase (PECVD) auf der Rückseite des Solarzellensubstrats abgeschieden und hierbei ein direktes Plasma verwendet. Wie eingangs erwähnt, kann auf diese Weise eine dichtere dielektrische Beschichtung erzeugt werden als mit indirekten Plasmen, was sich vorteilhaft auf die Verwendung der dielektrischen Beschichtung als Diffusions- und/oder Ätzbarriere auswirkt.

Nach dem Abscheiden der dielektrischen Beschichtung kann eine Emitterdiffusion zur Ausbildung eines Emitters auf einer Vorderseite des Solarzellensubstrats durchgeführt und die dielektrische Beschichtung während der Emitterdiffusion als Diffusionsbarriere gegenüber einer Eindiffusion von Dotierstoff in die Rückseite des Solarzellensubstrats verwendet werden. Dies ermöglicht eine aufwandsgünstige einseitige Emitterdiffusion aus der Gasphase.

Vorteilhafterweise wird das Solarzellensubstrat nach dem Abscheiden der dielektrischen Beschichtung in einem Texturätzmedium geätzt, um auf der Vorderseite des Solarzellensubstrats eine Textur auszubilden. Dabei wird die dielektrische Beschichtung während des Ätzens als Ätzbarriere gegenüber einem Ätzen der Rückseite des Solarzellensubstrats verwendet.

Bevorzugt wird als Solarzellensubstrat ein Siliziumsubstrat verwendet.

Sofern anstatt eines flächigen Kontakts ein Kontaktierungsnetz aus mehreren sich schneidenden Kontaktlinien oder Kontaktbändern verwendet werden soll, kann die der Erfindung zu Grunde liegende Aufgabe gelöst werden, indem in der Umgebung derjenigen Bereiche, welche während des Abscheidens der dielektrischen Beschichtung von den Haltenasen abgeschattet gewesen sind, Kontaktlinien oder Kontaktbänder derart verkürzt ausgeführt werden, dass die während des Abscheidens der dielektrischen Beschichtung von den Haltenasen abgeschatteten Bereiche frei von Kontaktlinien und Kontaktbändern sind. Auf diesen Bereichen verläuft demzufolge weder eine Kontaktlinie noch ein Kontaktband. Lokale Kurzschlüsse könne so vermieden werden. Eine entsprechend gestaltete Solarzelle würde demzufolge in diesen Bereichen verkürzte Kontaktlinien oder -bänder aufweisen. Vorzugsweise werden Kontaktlinien und -bänder derart verkürzt, dass sie von abgeschatteten Bereichen mindestens 1 mm beabstandet sind.

Weiterhin besteht die Möglichkeit, dem der Erfindung zu Grunde liegenden Problem zu begegnen, indem ein konventioneller, flächiger Kontakt wie eingangs beschrieben mit verringerter Höhe und Breite ausgeführt wird, der flächige Kontakt aber zusätzlich näher an diejenigen Kanten herangerückt wird, an welchen keine während des Abscheidens der dielektrischen Beschichtung von den Haltenasen abgeschatteten Bereiche existieren. Auf diese Weise kann der mit dem Verringern von Höhe und Breite einhergehende Verlust an Kontaktfläche reduziert und die hieraus resultierende Wirkungsgradbeeinträchtigung verringert werden. Allerdings bestehen höhere Anforderungen an die Ausrichtung der Solarzellensubstrate während des Fertigungsprozesses. Entsprechend gefertigte Solarzellen weisen sodann einen bezüglich der Kanten der Solarzelle unsymmetrischen flächigen Kontakt auf ihrer Rückseite auf, welcher sehr nahe an zwei Kanten der Solarzelle liegt und von den übrigen zwei Kanten weiter beabstandet ist.

Im Weiteren wird die Erfindung anhand von Figuren näher erläutert. Soweit zweckdienlich sind hierin gleichwirkende Elemente mit gleichen Bezugszeichen versehen. Es zeigen:
- Figur 1: Schematische Teildarstellung einer Solarzellenrückseite gemäß dem Stand der Technik in perspektivischer Ansicht
- Figur 2: Schematische Teildarstellung eines ersten Ausführungsbeispiels der erfindungsgemäßen Solarzelle in perspektivischer Ansicht
- Figur 3: Rückansicht eines zweiten Ausführungsbeispiels der erfindungsgemäßen Solarzelle in einer schematischen Darstellung
- Figur 4: Rückansicht eines dritten Ausführungsbeispiels der erfindungsgemäßen Solarzelle in einer schematischen Darstellung
- Figur 5: Prinzipdarstellung eines Ausführungsbeispiels des erfindungsgemäßen Verfahrens
- Figur 6: Mikroskopaufnahme eines während der Abscheidung einer dielektrischen Beschichtung abgeschatteten Bereichs einer Rückseite eines Solarzellensubstrats
- Figur 7: Thermographieaufnahme einer Solarzelle gemäß dem Stand der Technik

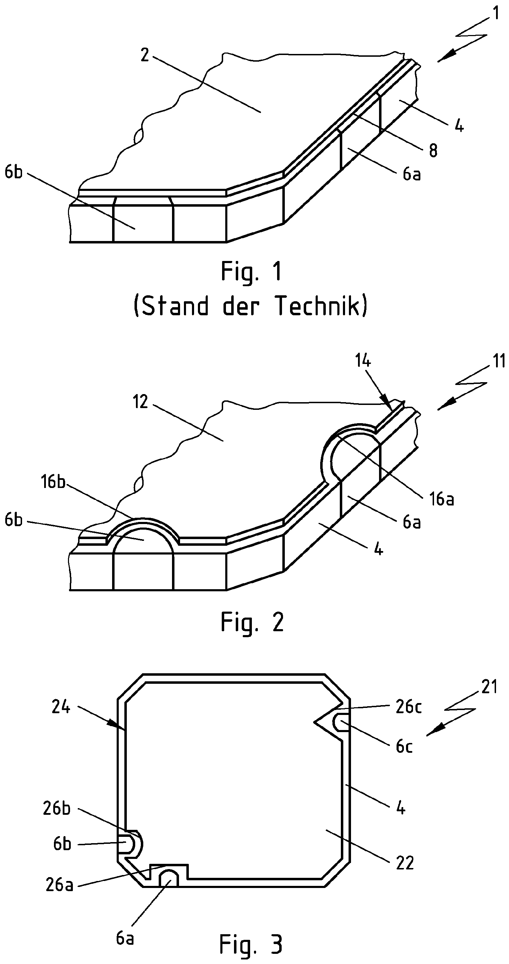

Figur 1 zeigt in schematischer Darstellung eine perspektivische Ansicht einer Rückseite einer Solarzelle 1 gemäß dem Stand der Technik. Auf der Rückseite der Solarzelle 1 ist eine dielektrische Beschichtung 4, beispielsweise eine Oxid-Nitrid-Beschichtung, angeordnet. Diese bedeckt teilweise auch Kanten der Solarzelle 11. Auf der Rückseite der Solarzelle 1 ist ferner ein flächiger Kontakt 2 vorgesehen, welcher die dielektrische Beschichtung 4 teilweise bedeckt. Dabei bedeckt der flächige Kontakt 2 auch Bereiche 6a, 6b, welche bei einer Abscheidung der dielektrischen Beschichtung 4 von Haltenasen abgeschattet worden sind. Diese sind in der Figur 1 in weißer Farbe dargestellt. Die abgeschatteten Bereiche 6a, 6b erstrecken sich von den Kanten der Solarzelle 1 ausgehend bis auf die Rückseite der Solarzelle 1 und sind nicht oder nur von einer wesentlich dünneren dielektrischen Schicht bedeckt als die übrigen Bereiche der Rückseite der Solarzelle, welche von der dielektrischen Beschichtung 4 bedeckt sind. Da bei der Solarzelle 1 in die abgeschatteten Bereiche 6a, 6b im Rahmen einer nach Aufbringen der dielektrischen Beschichtung 4 erfolgten Emitterdiffusion Emitterdotierstoff eindiffundiert worden ist, ergeben sich durch die Kontaktierung der abgeschatteten Bereiche 6a, 6b mittels des flächigen Kontakts 2 lokale Kurzschlüsse 8 in den abgeschatteten Bereichen 6a, 6b.

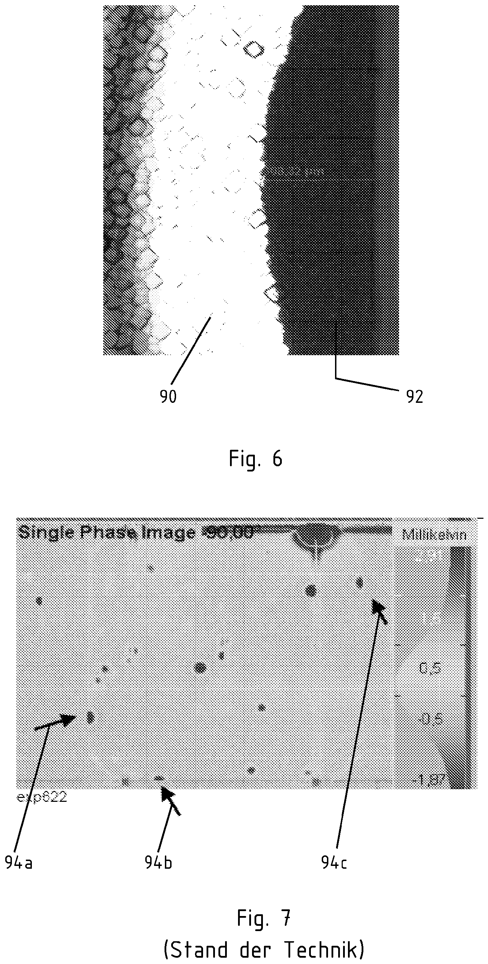

Dass solche lokalen Kurzschlüsse ein erhebliches Problem für die Solarzelle darstellen, illustrieren die Figuren 6 und 7. Figur 6 zeigt eine Mikroskopaufnahme eines während einer Abscheidung einer dielektrischen Beschichtung abgeschatteten Bereichs einer Rückseite eines Solarzellensubstrats. Auf der rechten Bildseite erscheint ein nicht von Teilen der dielektrischen Beschichtung bedeckter Bereich 92 der Rückseite des Solarzellensubstrats schwarz. An diesen Bereich 92 ohne dielektrische Beschichtung schließt sich auf dessen linker Seite eine dielektrische Beschichtung 90 an, welche auf der Mikroskopaufnahme hell erscheint. Die links von dem hellen Bereich auftretende Verfärbung kommt dadurch zustande, dass die dielektrische Beschichtung 90 mit zunehmendem Abstand von der Haltenase dicker wird, bis keine Abschattungseffekte mehr vorliegen und eine Maximaldicke erreicht ist. Figur 6 illustriert somit, dass Haltenasen durch Abschattung eine lokal verringerte Abscheidung der dielektrischen Beschichtung bewirken können. Teilweise können sie die Abscheidung der dielektrischen Schicht lokal sogar gänzlich verhindern.

Dass die hieraus resultierenden Kurzschlüsse ein relevantes Ausmaß erreichen, wird aus Figur 7 ersichtlich. Diese zeigt eine Thermographieaufnahme einer Solarzelle. Kurzschlüsse sind hierin als dunkler Fleck erkennbar. Die mittels Pfeilen 94a, 94b, 94c gekennzeichneten lokalen Kurzschlüsse sind auf Grund ihrer Lage eindeutig während der Abscheidung der dielektrischen Beschichtung abgeschatteten Bereichen zuzuordnen. Wie Figur 7 zeigt, handelt es sich bei diesen lokalen Kurzschlüssen um massive Kurzschlüsse, die sich negativ auf den Wirkungsgrad der Solarzelle auswirken.

Figur 2 zeigt in perspektivischer Ansicht eine schematische Teildarstellung eines ersten Ausführungsbeispiels der erfindungsgemäßen Solarzelle. Diese ist als Siliziumsolarzelle 11 ausgeführt, auf deren Rückseite eine dielektrische Beschichtung 4, beispielsweise eine PECVD-Oxid-Nitrid-Beschichtung, angeordnet ist. Diese ist teilweise von einem flächigen Kontakt 12 bedeckt. Der flächige Kontakt 12 weist eine Berandungslinie 14 auf, welche in der perspektivischen Darstellung der Figur 2 dem Kantenverlauf des flächigen Kontakts folgt und die Rücksprünge 16a, 16b aufweist. Durch die Rücksprünge 16a, 16b werden die abgeschatteten Bereiche 6a, 6b frei von dem flächigen Kontakt 12 gehalten, sodass keine lokalen Kurzschlüsse entstehen. In einer Ausführungsvariante kann in den abgeschatteten Bereichen 6a, 6b eine dielektrische Beschichtung vorliegen, deren Dicke weniger als 50%, vorzugsweise weniger als 30% und besonders bevorzugt weniger als 10%, der Maximaldicke der dielektrischen Beschichtung 4 beträgt. In einer anderen Ausführungsvariante können die abgeschatteten Bereiche 6a, 6b vollständig frei von einer dielektrischen Beschichtung sein.

Figur 3 zeigt eine Rückansicht eines zweiten Ausführungsbeispiels der erfindungsgemäßen Solarzelle in schematischer Darstellung. Hierbei handelt es sich erneut um eine Siliziumsolarzelle 21, auf deren Rückseite die dielektrische Beschichtung 4 angeordnet ist. Diese ist teilweise von einem flächigen Kontakt 22 bedeckt, dessen Berandungslinie 24 drei Rücksprünge 26a, 26b, 26c aufweist. Durch die Rücksprünge 26a, 26b, 26c werden die bei der Abscheidung der dielektrischen Beschichtung 4 abgeschatteten Bereiche 6a, 6b, 6c von dem flächigen Kontakt 22 frei gehalten. Wie im Fall der Figur 2 kann in den abgeschatteten Bereichen eine dielektrische Beschichtung verringerter Dicke oder gar keine dielektrische Beschichtung vorliegen.

Wie Figur 3 illustriert, können die Rücksprünge 26a, 26b, 26c in verschiedenen Formen gestaltet werden. Dies ermöglicht eine Anpassung an die Bedürfnisse des jeweiligen Herstellungsprozesses.

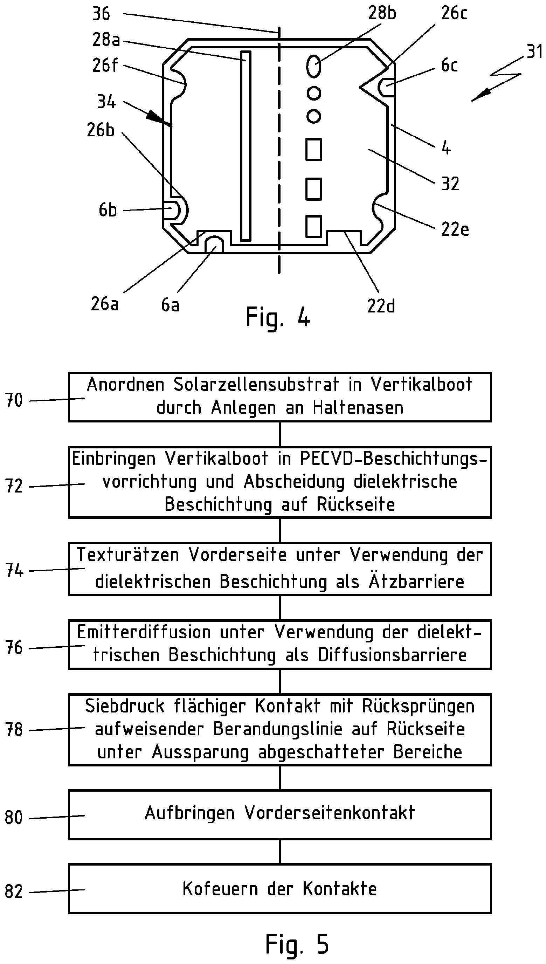

Figur 4 zeigt ein drittes Ausführungsbeispiels der erfindungsgemäßen Solarzelle in einer schematisch dargestellten Rückansicht. Erneut handelt es sich um eine Siliziumsolarzelle 31. Diese unterscheidet sich von der Siliziumsolarzelle 21 aus Figur 3 zum einen dadurch, dass sie einen flächigen Kontakt 32 aufweist, dessen Berandungslinie 34 sechs Rücksprünge 26a, 26b, 26c, 26d, 26e, 26f anstatt drei Rücksprünge aufweist. Diese Rücksprünge 26a, 26b, 26c, 26d, 26e, 26f sind spiegelsymmetrisch zu einer in Figur 4 gestrichelt dargestellten Spiegelgeraden 36 angeordnet, welche in derselben Ebene verläuft wie der flächige Kontakt 32. Auf diese Weise kann der flächige Kontakt 32, wie oben näher beschrieben, auch für Solarzellen, beziehungsweise Solarzellensubstrate, verwendet werden, bei welchen die abgeschatteten Bereiche seitenverkehrt angeordnet sind.

Wie Figur 4 illustriert, ist es nicht zwingend erforderlich, dass die Rücksprünge 26a, 26b, 26c, 26d, 26e, 26f spiegelsymmetrisch zu der Spiegelebene 36 gestaltet sind. So weist beispielsweise der Rücksprung 26f eine andere Gestalt auf als der spiegelsymmetrisch zu ihm angeordnete Rücksprung 26c. Eine spiegelsymmetrische Anordnung ist grundsätzlich ausreichend.

Des Weiteren unterscheidet sich die Siliziumsolarzelle 34 der Figur 4 von der aus Figur 3 dadurch, dass auf dem flächigen Kontakt 34 Lötkontakte 28a, 28b angeordnet sind. Diese können beispielsweise durch silberhaltige Siebdruckkontakte gebildet sein und dienen der Verschaltung der Solarzelle in einem Solarzellenmodul. Wie aus Figur 4 ersichtlich wird, können die Lötkontakte als durchgehender Lötkontakt 28a oder als unterbrochener Lötkontakt 28b ausgeführt sein, wobei einzelne Lötkontaktbestandteile des unterbrochenen Lötkontakts 28b grundsätzliche verschiedene geometrische Gestalten aufweisen können. Diese sind an die Anforderungen des jeweiligen Einzelfalls anzupassen.

In den Ausführungsbeispielen der Figuren 2 bis 4 ist der flächige Kontakt mittels Siebdruck aufgebracht. Bei der dielektrischen Beschichtung 4 handelt es sich um eine PECVD-Oxid-Nitrid-Beschichtung. Grundsätzlich sind andere Beschichtungen und Druckverfahren ebenfalls einsetzbar.

Die Prinzipdarstellung der Figur 5 illustriert ein Ausführungsbeispiel des erfindungsgemäßen Verfahrens. Bei diesem wird das Solarzellensubstrat zunächst in einem Vertikalboot angeordnet 70, indem es an Haltenasen angelegt wird. Im Weiteren wird das Vertikalboot in eine PECVD-Beschichtungsvorrichtung eingebracht 72 und unter Verwendung eines direkten Plasmas eine dielektrische Beschichtung auf einer Rückseite des Solarzellensubstrats abgeschieden 72. Als dielektrische Beschichtung wird dabei bevorzugt eine Oxid-Nitrid-Beschichtung abgeschieden. Im Weiteren erfolgt ein Texturätzen 74 einer Vorderseite des Solarzellensubstrats. Die dielektrische Beschichtung wird dabei als Ätzbarriere gegen ein eingesetztes Texturätzmedium verwendet, sodass die Rückseite des Solarzellensubstrats nicht texturiert wird. Hieran schließt sich eine Emitterdiffusion 76 an, bei welcher die dielektrische Beschichtung auf der Rückseite des Solarzellensubstrats als Diffusionsbarriere gegen eine Eindiffusion von Emitterdotierstoff in die Rückseite des Solarzellensubstrats verwendet wird. Im Weiteren wird mittels eines Siebdruckverfahrens ein flächiger Kontakt mit einer Rücksprünge aufweisenden Berandungslinie auf die Rückseite des Solarzellensubstrats aufgedruckt 78. Die Rücksprünge werden dabei derart ausgestaltet und angeordnet, dass alle Bereiche, welche während des Abscheidens 72 der dielektrischen Beschichtung von den Haltenasen abgeschattet gewesen sind, von einer Bedeckung mit dem flächigen Kontakt ausgespart werden 78. Im Weiteren wird in an sich bekannter Weise ein Vorderseitenkontakt auf die Vorderseite des Solarzellensubstrats aufgebracht 80. Im Ausführungsbeispiel der Figur 5 erfolgt dies durch Siebdrucken des Vorderseitenkontakts. Im Weiteren werden der flächige Kontakt und der Vorderseitenkontakt kogefeuert 82 und in dieser Weise ohmsche Kontakte zur Vorder- bzw. Rückseite des Solarzellensubstrats ausgebildet. Die Kontakte können dabei durch etwaige Antireflexionsschichten hindurchgefeuert werden.

In den in Figur 5 dargestellten Verfahrensablauf können ohne Weiteres zusätzliche Verfahrensschritte integriert werden, beispielsweise solche zur Ausbildung einer selektiven Emitterstruktur. Umgekehrt kann der Verfahrensablauf des Ausführungsbeispiels der Figur 5 einfach in andere Herstellungsverfahren integriert werden, beispielsweise in die in der deutschen Patentanmeldung Nr. 10 2010 025 983.7 beschriebenen Solarzellenherstellungsverfahren. Dabei ist es nicht erforderlich, dass die einzelnen Verfahrensschritte des Ausführungsbeispiels der Figur 5 unmittelbar aufeinanderfolgen.

### Bezugszeichenliste

- 1: Solarzelle
- 2: flächiger Kontakt
- 4: dielektrische Beschichtung
- 6a: abgeschatteter Bereich
- 6b: abgeschatteter Bereich
- 6c: abgeschatteter Bereich
- 8: elektrischer Kurzschluss

- 11: Siliziumsolarzelle
- 12: flächiger Kontakt
- 14: Berandungslinie
- 16a: Rücksprung
- 16b: Rücksprung

- 21: Siliziumsolarzelle
- 22: flächiger Kontakt
- 24: Berandungslinie
- 26a: Rücksprung
- 26b: Rücksprung
- 26c: Rücksprung
- 26d: Rücksprung
- 26e: Rücksprung
- 26f: Rücksprung
- 28a: Lötkontakt
- 28b: Lötkontakt

- 31: Siliziumsolarzelle
- 32: flächigen Kontakt
- 34: Berandungslinie
- 36: Spiegelgerade

- 70: Anordnen Solarzellensubstrat in Vertikalboot
- 72: Einbringen Vertikalboot in Beschichtungsvorrichtung und Abscheidung dielektrische Beschichtung
- 74: Texturätzen
- 76: Emitterdiffusion
- 78: Siebdruck flächiger Kontakt auf Rückseite

- 80: Aufbringen Vorderseitenkontakt
- 82: Kofeuern

- 90: dielektrische Beschichtung
- 92: abgeschatteter Bereich ohne dielektrische Beschichtung
- 94a: Kurzschluss
- 94b: Kurzschluss
- 94c: Kurzschluss

## Patentansprüche

1. Verfahren zur Herstellung einer Solarzelle (11; 21; 31), bei welchem
- ein Solarzellensubstrat in einer wenigstens eine Haltenase aufweisenden Haltevorrichtung angeordnet (70) und dabei an der wenigstens einen Haltenase angelegt wird (70),
- die Haltevorrichtung in eine Beschichtungsvorrichtung eingebracht und eine dielektrische Beschichtung (4) auf der Rückseite des Solarzellensubstrats abgeschieden wird (72),
- zumindest auf Teile der dielektrischen Beschichtung (4) ein flächiger Kontakt (12; 22; 32) aufgebracht wird (78),
- bei dem Aufbringen (78) des flächigen Kontakts (12; 22; 32) zumindest auf Teile der dielektrischen Beschichtung (4) diejenigen Bereiche (6a, 6b, 6c) ausgespart werden (78), welche während des Abscheidens der dielektrischen Beschichtung (4) von den Haltenasen abgeschattet gewesen sind,
- der flächige Kontakt (12; 22; 32) derart ausgestaltet wird (78), dass dessen Berandungslinie (14; 24; 34) wenigstens einen Rücksprung (16a; 26a) aufweist, und
- der flächige Kontakt (12; 22; 32) derart ausgestaltet und angeordnet wird (78), dass der wenigstens eine Rücksprung (16a; 26a) zumindest einen Teil derjenigen Bereiche (6a, 6b, 6c) von einer Bedeckung mit dem flächigen Kontakt (12; 22; 32) ausspart, die während des Abscheidens der dielektrischen Beschichtung (4) von den Haltenasen abgeschattet gewesen sind.

2. Verfahren nach Anspruch 1,
**dadurch gekennzeichnet,**
**dass** als Haltevorrichtung ein Vertikalboot verwendet wird (70) .

3. Verfahren nach einem der vorangegangenen Ansprüche,
**dadurch gekennzeichnet,**
**dass** für jeden während des Abscheidens der dielektrischen Beschichtung (4) von Haltenasen abgeschatteten Bereich (6a; 6b; 6c) ein Rücksprung (16a; 26a, 26b, 26c) vorgesehen wird, und jeder dieser Rücksprünge (16a; 26a, 26b, 26c) derart ausgestaltet und angeordnet wird, dass er denjenigen Bereich (6a, 6b, 6c) zumindest teilweise von einer Bedeckung mit dem flächigen Kontakt (12; 22; 32) ausspart, welcher während des Abscheidens der dielektrischen Beschichtung (4) von der zugehörigen Haltenase abgeschattet gewesen ist.

4. Verfahren nach einem der vorangegangenen Ansprüche,
**dadurch gekennzeichnet,**
**dass** der flächige Kontakt (12; 22; 32) aufgedruckt wird (78) .

5. Verfahren nach einem der vorangegangenen Ansprüche,
**dadurch gekennzeichnet,**
**dass** die dielektrische Beschichtung (4) mittels einer plasmagetriebenen Abscheidung aus der Dampfphase auf der Rückseite des Solarzellensubstrats abgeschieden wird (72) und hierbei ein direktes Plasma verwendet wird.

6. Verfahren nach einem der vorangegangenen Ansprüche,
**dadurch gekennzeichnet,**
**dass** nach dem Abscheiden der dielektrischen Beschichtung (4) eine Emitterdiffusion zur Ausbildung eines Emitters auf einer Vorderseite des Solarzellensubstrats durchgeführt wird (76) und die dielektrische Beschichtung (4) während der Emitterdiffusion als Diffusionsbarriere gegenüber einer Eindiffusion von Dotierstoff in die Rückseite des Solarzellensubstrats verwendet wird (76).

7. Verfahren nach einem der vorangegangenen Ansprüche,
**dadurch gekennzeichnet,**
**dass** das Solarzellensubstrat nach dem Abscheiden der dielektrischen Beschichtung (4) in einem Texturätzmedium geätzt wird (74), um auf der Vorderseite des Solarzellensubstrats eine Textur auszubilden, und die dielektrische Beschichtung (4) während des Ätzens als Ätzbarriere gegenüber einem Ätzen der Rückseite des Solarzellensubstrats verwendet wird (74).

8. Solarzelle (11; 21; 31) aufweisend eine auf einer Rückseite der Solarzelle (11; 21; 31) angeordnete dielektrische Beschichtung (4), welche zumindest teilweise von wenigstens einem flächigen Kontakt (12; 22; 32) bedeckt ist, wobei eine Berandungslinie (14; 24; 34) des wenigstens einen flächigen Kontakts (12; 22; 32) mindestens einen Rücksprung (16a, 16b; 26a, 26b, 26c) aufweist,
**dadurch gekennzeichnet,**
**dass** in einem durch den mindestens einen Rücksprung (16a, 16b; 26a, 26b, 26c) von dem flächigen Kontakt (12; 22; 32) frei gehaltenen Bereich der Rückseite die dielektrische Beschichtung (4) zumindest abschnittsweise eine Dicke von weniger als 50% ihrer maximalen Dicke aufweist.

9. Solarzelle (11; 21; 31) aufweisend eine auf einer Rückseite der Solarzelle (11; 21; 31) angeordnete dielektrische Beschichtung (4), welche zumindest teilweise von wenigstens einem flächigen Kontakt (12; 22; 32) bedeckt ist, wobei eine Berandungslinie (14; 24; 34) des wenigstens einen flächigen Kontakts (12; 22; 32) mindestens einen Rücksprung (16a, 16b; 26a, 26b, 26c) aufweist,
**dadurch gekennzeichnet,**
**dass** ein durch den mindestens einen Rücksprung (16a, 16b; 26a, 26b, 26c) von dem flächigen Kontakt (12; 22; 32) frei gehaltener Bereich der Rückseite zumindest abschnittsweise frei von der dielektrischen Beschichtung (4) ist.

10. Solarzelle (11; 21) nach einem der Ansprüche 8 bis 9,
**dadurch gekennzeichnet,**
**dass** die Berandungslinie (14; 24) zwei Rücksprünge (16a, 16b; 26a, 26b, 26c) aufweist.

11. Solarzelle (31) nach einem der Ansprüche 8 bis 10,
**dadurch gekennzeichnet,**
**dass** die Berandungslinie (34) mehrere Rücksprünge (26a, 26b, 26c, 26d, 26e, 26f) aufweist und die Rücksprünge (26a, 26b, 26c, 26d, 26e, 26f) spiegelsymmetrisch zu einer in einer Ebene des flächigen Kontakts (32) verlaufenden Geraden (36) angeordnet sind.

12. Solarzelle (11; 21; 31) nach einem der Ansprüche 8 bis 11,
**dadurch gekennzeichnet,**
**dass** der flächige Kontakt (12; 22; 32) mittels Siebdruck aufgebracht ist.

## Claims

1. Method for producing a solar cell (11; 21; 31), wherein
- a solar cell substrate is arranged (70) in a holding device having at least one holding lug and in the process is placed (70) against the at least one holding lug,
- the holding device is introduced into a coating device and a dielectric coating (4) is deposited (72) on the back side of the solar cell substrate,
- a planar contact (12; 22; 32) is applied (78) at least to parts of the dielectric coating (4),
- in the course of applying (78) the planar contact (12; 22; 32) at least to parts of the dielectric coating (4), those regions (6a, 6b, 6c) are omitted (78) which were shaded by the holding lugs during the deposition of the dielectric coating (4),
- the planar contact (12; 22; 32) is configured (78) in such a way that its boundary line (14; 24; 34) has at least one recess (16a; 26a), and
- the planar contact (12; 22; 32) is configured and arranged (78) in such a way that the at least one recess (16a; 26a) omits from a covering with the planar contact (12; 22; 32) at least one portion of those regions (6a, 6b, 6c) which were shaded by the holding lugs during the deposition of the dielectric coating (4).

2. Method according to Claim 1,
**characterized**
**in that** a vertical boat is used (70) as the holding device.

3. Method according to either of the preceding claims, **characterized**
**in that** a recess (16a; 26a, 26b, 26c) is provided for each region (6a; 6b; 6c) shaded by holding lugs during the deposition of the dielectric coating (4), and each of said recesses (16a; 26a, 26b, 26c) is configured and arranged in such a way that it omits at least partly from a covering with the planar contact (12; 22; 32) that region (6a, 6b, 6c) which was shaded by the associated holding lug during the deposition of the dielectric coating (4).

4. Method according to any of the preceding claims,
**characterized**
**in that** the planar contact (12; 22; 32) is applied (78) by printing.

5. Method according to any of the preceding claims,
**characterized**
**in that** the dielectric coating (4) is deposited (72) on the back side of the solar cell substrate by means of a plasma-enhanced vapor deposition and a direct plasma is used in the process.

6. Method according to any of the preceding claims,
**characterized**
**in that** after the deposition of the dielectric coating (4), an emitter diffusion is carried out (76) in order to form an emitter on a front side of the solar cell substrate and, during the emitter diffusion, the dielectric coating (4) is used (76) as a diffusion barrier against indiffusion of dopant into the back side of the solar cell substrate.

7. Method according to any of the preceding claims,
**characterized**
**in that** after the deposition of the dielectric coating (4), the solar cell substrate is etched (74) in a texture etching medium in order to form a texture on the front side of the solar cell substrate, and, during the etching, the dielectric coating (4) is used (74) as an etching barrier against etching of the back side of the solar cell substrate.

8. Solar cell (11; 21; 31) having a dielectric coating (4) arranged on a back side of the solar cell (11; 21; 31), said dielectric coating being at least partly covered by at least one planar contact (12; 22; 32), wherein a boundary line (14; 24; 34) of the at least one planar contact (12; 22; 32) has at least one recess (16a, 16b; 26a, 26b, 26c),
**characterized**
**in that** in a region of the back side that is kept free of the planar contact (12; 22; 32) by the at least one recess (16a, 16b; 26a, 26b, 26c), the dielectric coating (4) at least in sections has a thickness of less than 50% of its maximum thickness.

9. Solar cell (11; 21; 31) having a dielectric coating (4) arranged on a back side of the solar cell (11; 21; 31), said dielectric coating being at least partly covered by at least one planar contact (12; 22; 32), wherein a boundary line (14; 24; 34) of the at least one planar contact (12; 22; 32) has at least one recess (16a, 16b; 26a, 26b, 26c),
**characterized**
**in that** a region of the back side that is kept free of the planar contact (12; 22; 32) by the at least one recess (16a, 16b; 26a, 26b, 26c) is free from the dielectric coating (4) at least in sections.

10. Solar cell (11; 21) according to either of Claims 8 and 9,
**characterized**
**in that** the boundary line (14; 24) has two recesses (16a, 16b; 26a, 26b, 26c) .

11. Solar cell (31) according to any of Claims 8 to 10,
**characterized**
**in that** the boundary line (34) has a plurality of recesses (26a, 26b, 26c, 26d, 26e, 26f) and the recesses (26a, 26b, 26c, 26d, 26e, 26f) are arranged mirror-symmetrically with respect to a straight line (36) extending in a plane of the planar contact (32).

12. Solar cell (11; 21; 31) according to any of Claims 8 to 11,
**characterized**
**in that** the planar contact (12; 22; 32) is applied by means of screen printing.

## Revendications

1. Procédé de fabrication d'une cellule solaire (11 ; 21 ; 31), où
- un substrat de cellule solaire est agencé (70) dans un dispositif de maintien comportant au moins un bec de maintien et est ainsi appliqué (70) à l'au moins un bec de maintien,
- le dispositif de maintien est pratiqué dans un dispositif de revêtement et un revêtement diélectrique (4) est déposé (72) sur la face arrière du substrat de cellule solaire,
- un contact plat (12 ; 22 ; 32) est arrangé (78) sur au moins des parties du revêtement diélectrique (4),
- lors de l'arrangement (78) du contact plat (12 ; 22 ; 32) sur au moins des parties du revêtement diélectrique (4), chacune des zones (6a, 6b, 6c) masquées par les becs de maintien pendant le dépôt du revêtement diélectrique (4) est ignorée (78),
- le contact plat (12 ; 22 ; 32) est configuré (78) de telle sorte que sa ligne de bordure (14 ; 24 ; 34) comporte au moins un retrait (16a ; 26a), et
- le contact plat (12 ; 22 ; 32) est configuré et agencé (78) de telle sorte que l'au moins un retrait (16a ; 26a) laisse exempte d'un recouvrement par le contact plat (12 ; 22 ; 32), au moins une partie de chacune des zones (6a, 6b, 6c) qui sont masquées par les becs de maintien pendant le dépôt du revêtement diélectrique (4).

2. Procédé selon la revendication 1, **caractérisé en ce qu'**une nacelle verticale est utilisée (70) comme dispositif de maintien.

3. Procédé selon l'une des revendications précédentes, **caractérisé en ce qu'**un retrait (16a ; 26a, 26b, 26c) est prévu pour chaque zone (6a, 6b, 6c) masquée par les becs de maintien pendant le dépôt du revêtement diélectrique (4), et chacun de ces retraits (16a ; 26a, 26b, 26c) est configuré et agencé de telle sorte qu'il laisse exempte au moins partiellement d'un recouvrement par le contact plat (12 ; 22 ; 32) chaque zone (6a, 6b, 6c) masquée par le bec de maintien associé pendant le dépôt du revêtement diélectrique (4) .

4. Procédé selon l'une des revendications précédentes, **caractérisé en ce que** le contact plat (12 ; 22 ; 32) est imprimé (78).

5. Procédé selon l'une des revendications précédentes, **caractérisé en ce que** le revêtement diélectrique (4) est déposé (72) au moyen d'une déposition en phase vapeur assistée par plasma sur la face arrière du substrat de cellule solaire et un plasma direct est utilisé à cet effet.

6. Procédé selon l'une des revendications précédentes, **caractérisé en ce qu'**après la déposition du revêtement électrique (4) une diffusion de l'émetteur destinée à réaliser un émetteur sur une face avant du substrat de cellule solaire est effectuée (76) et le revêtement diélectrique (4) est utilisé (76) pendant la diffusion de l'émetteur comme barrière de diffusion contre une diffusion d'entrée de dopant dans la face arrière du substrat de cellule solaire.

7. Procédé selon l'une des revendications précédentes, **caractérisé en ce qu'**après la déposition du revêtement électrique (4) le substrat de cellule solaire est gravé (74) dans un milieu de gravure de texturation, afin de réaliser une texture sur la face avant du substrat de cellule solaire, et le revêtement diélectrique (4) est utilisé (74) pendant la gravure comme barrière de gravure contre une gravure de la face arrière du substrat de cellule solaire.

8. Cellule solaire (11 ; 21 ; 31) comportant un revêtement diélectrique (4) agencé sur la face arrière de la cellule solaire (11 ; 21 ; 31), lequel est recouvert au moins partiellement par au moins un contact plat (12 ; 22 ; 32), dans laquelle une ligne de bordure (14 ; 24 ; 34) de l'au moins un contact plat (12 ; 22 ; 32) comporte au moins un retrait (16a, 16b ; 26a, 26b, 26c), **caractérisée en ce que** dans une zone de la face arrière maintenue libre du contact plat (12 ; 22 ; 32) par l'au moins un retrait (16a, 16b ; 26a, 26b, 26c), le revêtement diélectrique (4) possède au moins par sections une épaisseur inférieure à 50 % de son épaisseur maximale.

9. Cellule solaire (11 ; 21 ; 31) comportant un revêtement diélectrique (4) agencé sur la face arrière de la cellule solaire (11 ; 21 ; 31), lequel est recouvert au moins partiellement par au moins un contact plat (12 ; 22 ; 32), dans laquelle une ligne de bordure (14 ; 24 ; 34) de l'au moins un contact plat (12 ; 22 ; 32) comporte au moins un retrait (16a, 16b ; 26a, 26b, 26c), **caractérisée en ce qu'**une zone de la face arrière maintenue libre du contact plat (12 ; 22 ; 32) par l'au moins un retrait (16a, 16b ; 26a, 26b, 26c) est, au moins par sections, libre du revêtement diélectrique (4).

10. Cellule solaire (11 ; 21) selon l'une des revendications 8 et 9, **caractérisée en ce que** la ligne de bordure (14 ; 24) comporte deux retraits (16a, 16b ; 26a, 26b, 26c).

11. Cellule solaire (31) selon l'une des revendications 8 à 10, **caractérisée en ce que** la ligne de bordure (34) comporte plusieurs retraits (26a, 26b, 26c, 26d, 26e, 26f) et les retraits (26a, 26b, 26c, 26d, 26e, 26f) sont agencés en symétrie de réflexion par rapport à une droite (36) s'étendant dans un plan du contact plat (32).

12. Cellule solaire (11 ; 21 ; 31) selon l'une des revendications 8 à 11, **caractérisée en ce que** le contact plat (12 ; 22 ; 32) est arrangé au moyen d'une sérigraphie.
